# EUROPÄISCHE PATENTANMELDUNG

(11) **EP 3 945 572 A1**
(43) Veröffentlichungstag der Anmeldung: **02.02.2022**
(21) Anmeldenummer: 20188637.1
(22) Anmeldetag: 30.07.2020
(51) Int. Cl.: H01L 25/07, H02M 7/00

(54) **LEISTUNGSHALBLEITERMODUL UND HERSTELLUNGSVERFAHREN FÜR EIN LEISTUNGSHALBLEITERMODUL**

(71) Anmelder: Siemens Aktiengesellschaft, 80333 München (DE)
(72) Erfinder: Lorz, Roland, 91341 Röttenbach (DE); Kneißl, Philipp, 90427 Nürnberg (DE)

(57) **Zusammenfassung**

Vorgeschlagen wird ein Leistungshalbleitermodul (1), das eine Leistungshalbleiterschaltung und ein Gehäuse (2) aufweist, wobei das Gehäuse (2) die Leistungshalbleiterschaltung wenigstens teilweise umgibt, und wobei die Leistungshalbleiterschaltung eine erste Kontaktelektrode (3) und eine zweite Kontaktelektrode (4) aufweist, die jeweils mit der Leistungshalbleiterschaltung elektrisch leitend verbunden sind, und die jeweils durch eine hierfür ausgebildete Ausnehmung (9, 10) in dem Gehäuse (2) durch das Gehäuse (2) nach außen geführt sind. Das Leistungshalbleitermodul (1) ist dadurch gekennzeichnet, dass das Gehäuse (2) einen ersten Kontaktierungsbereich (15), einen zweiten Kontaktierungsbereich (16) und einen dritten Kontaktierungsbereich (17) aufweist, wobei in dem ersten Kontaktierungsbereich (15) die erste Kontaktelektrode (3) kontaktierbar ist, und in dem zweiten Kontaktierungsbereich (16) die zweite Kontaktelektrode (4) kontaktierbar ist, und dass in dem dritten Kontaktierungsbereich (17) die erste Kontaktelektrode (3) und die zweite Kontaktelektrode (4) zusammen kontaktierbar sind.

## Beschreibung

Die Erfindung betrifft ein Leistungshalbleitermodul mit den Merkmalen des Oberbegriffs des Anspruchs 1. Zudem betrifft die Erfindung ein Gehäuse für ein Leistungshalbleitermodul, ein Leistungshalbleitermodulsystem mit einer Vielzahl von Leistungshalbleitermodulen und ein Verfahren zum Herstellen eines Leistungshalbleitermoduls.

Leistungshalbleiter werden zumeist in Gehäusen verpackt. Vor allem für höhere Leistungen werden mehrere Halbleiter in einem Gehäuse integriert, um höhere Ströme zu erreichen. Oftmals werden die Halbleiter einer "Halbbrücke" zusammen in ein Gehäuse integriert, um eine niederinduktive Verschaltung zu gewährleisten. Ein solches Halbbrückengehäuse kann drei Terminals (DC+, DC- und AC) aufweisen. Weil der AC-Anschluss eine höhere Strombelastung erfährt wird dieser oftmals doppelt bzw. verstärkt ausgeführt. Des Weiteren sind die DC- und DC+ Terminals nahe beieinanderliegend und können somit niederinduktiv ausgeführt werden.

Das Modulgehäuse hat viele unterschiedliche Aufgaben zu erfüllen, aus diesem Grunde ist der Entwicklungsaufwand und der Herstellungsaufwand (Spritzgussformen, Biegewergzeuge, Automatisierung etc.) sehr hoch und ist somit nur für hohe Stückzahlen profitabel.

Der Trend in der Leistungselektronik geht im Allgemeinen hin zu höheren Schaltfrequenzen und gleichzeitig geringeren Netzrückwirkungen. Hier werden zunehmend 3L-Topologien auch für höhere Leistungen eingesetzt. "3L" steht hierbei für "Three Level" und bedeutet, dass die Schaltung drei unterschiedliche Spannungspotentiale am AC-Ausgang aufweisen kann (z.B. DC+, DC- und DCM).

Für kleine Leistungen werden Pins (Löt oder Pressfit) zumeist am Rand des Gehäuses platziert. Falls die Modulkonstruktion auf Flexibilität ausgerichtet ist, können die Pins relativ flexibel positioniert werden. Hauptnachteile sind hierbei die geringe Stromtragfähigkeit dieser Pins und, bei höheren Strömen, der Stromfluss über die Leiterplatte.

Für höhere Leistungen werden sehr häufig Halbbrückenmodule eingesetzt. Diese haben sehr oft drei oder vier Leistungsanschlussterminals, in der Regel Schraubterminals, um darin möglichst effektiv (Komplexität, Kosten) eine 2-Level Halbbrücke zu realisieren. Für eine 3L Halbbrücke ist die Anordnung bzw. die Anzahl der Leistungsterminals nicht geeignet. Um dennoch eine 3L-Halbbrücke zu realisieren muss entweder ein eigenes, neues Modulgehäuse konstruiert werden (hoher Aufwand, hohe Investitionskosten, geringe Stückzahlen).

Alternativ kann die 3L-Halbbrücke in 2 Modulgehäusen realisiert werden. Zumeist wird hier zusätzlich zu einem 2L- Modul ein Modul mit Mittelpunktschaltern hinzugeschaltet. Ein großer Nachteil hiervon ist, dass diese Anordnung nicht für ein schnelles Schalten geeignet ist, da jeder Umschaltvorgang zwischen den beiden Modulen auftritt und nicht innerhalb eines Moduls abläuft.

Viele der derzeitig verfügbaren Modulgehäuse sind aufgrund ihrer Leistungsanschlüsse nur sehr bedingt für 3L-Topologieen geeignet. Andererseits sind die verfügbaren Stückzahlen für 3L-Module oftmals nicht hoch genug, um eine eigene Gehäuseneuentwicklung zu rechtfertigen.

In der EP 1 467 607 B1 ist ein Leistungsschaltermodul mit an einem Gehäuse eines Leistungshalbleiters angebrachten Kontaktelektroden offenbart.

Die WO 2017/216228 A1 offenbart eine Leistungshalbleiterschaltung mit einem zum Schalten einer Last bestimmten Leistungshalbleiter.

Der Erfindung liegt die Aufgabe zugrunde, ein Leistungshalbleitermodul anzugeben, das variabel für verschiedene Konfigurationsszenarien eingesetzt werden kann.

Diese Aufgabe wird gelöst durch ein Leistungshalbleitermodul nach Anspruch 1. Außerdem wird die Aufgabe gelöst durch ein Gehäuse für ein Leistungshalbleitermodul nach Anspruch 11. Außerdem wird die Aufgabe gelöst durch ein Verfahren zum Herstellen eines Leistungshalbleitermoduls nach Anspruch 13. Vorteilhafte Weiterbildungen ergeben sich aus den abhängigen Ansprüchen.

Gemäß Anspruch 1 weist ein erfindungsgemäßes Leistungshalbleitermodul eine Leistungshalbleiterschaltung und ein Gehäuse auf, wobei das Gehäuse die Leistungshalbleiterschaltung wenigstens teilweise umgibt, und wobei die Leistungshalbleiterschaltung eine erste Kontaktelektrode und eine zweite Kontaktelektrode aufweist, die jeweils mit der Leistungshalbleiterschaltung elektrisch leitend verbunden sind, und die jeweils durch eine hierfür ausgebildete Ausnehmung in dem Gehäuse durch das Gehäuse nach außen geführt sind. Das Leistungshalbleitermodul ist dadurch gekennzeichnet, dass das Gehäuse einen ersten, einen zweiten und einen dritten Kontaktierungsbereich aufweist, wobei in dem ersten Kontaktierungsbereich die erste Kontaktelektrode und in dem zweiten Kontaktierungsbereich die zweite Kontaktelektroden kontaktierbar ist, und dass in dem dritten Kontaktierungsbereich die erste Kontaktelektrode und die zweite Kontaktelektrode zusammen kontaktierbar sind.

Die Leistungshalbleiterschaltung kann zum Steuern und Schalten von elektrischen Strömen eingesetzt werden, die eine vergleichsweise große Stromstärke aufweisen, beispielsweise mehr als 50 Ampere. Die Leistungshalbleiterschaltung kann auf einem Substrat angeordnete Leistungshalbleiterbauelemente, wie z.B. IGBTs (Insulated Gate Bipolar Transistor), MOSFETs (Metal Oxide Semiconductor Field Effect Transistor), Thyristoren, Dioden und dergleichen umfassen, die mittels einer Leiterschicht des Substrats, sowie Bonddrähten und/oder einem Folienverbund miteinander elektrisch leitend verbunden sein können. Die auf dem Substrat angeordneten Leistungshalbleiterbauelemente können elektrisch zu einer einzelnen oder mehreren sogenannten Halbbrückenschaltungen verschalten sein, die z.B. zum Gleich- und Wechselrichten von elektrischen Spannungen und Strömen verwendet werden.

Zu den Aufgaben eines Gehäuses für ein Leistungshalbleitermodul können die mechanische Entlastung, das Führen und die Isolation der einzelnen Kontaktelektroden zählen. Im Rahmen der Erfindung kann ein beliebiges Gehäuse eingesetzt werden, welches die Leistungshalbleiterschaltung wenigstens teilweise umgibt, um u.a. die oben genannten Funktionen zu erfüllen.

Die Kontaktelektroden haben die Aufgabe, eine elektrische Leistung auf die Halbleiterschaltung zu übertragen. Hierzu sind die Kontaktelektroden derart ausgebildet, dass sie mit einer externen Spannungs-/Stromquelle elektrisch leitend verbunden werden können (z.B. durch Löten, Schweißen oder eine mechanische Verbindung wie Quetschen oder Schrauben). Die Kontaktelektroden müssen zu diesem Zweck wenigstens in Teilbereichen eine nicht zu vernachlässigende elektrische Leitfähigkeit aufweisen, um die Leistung an die Leistungshalbleiterschaltung leiten zu können. Die Kontaktelektroden können beispielsweise aus Kupfer, Eisennickel oder elektrisch leitendem Silizium sein.

Das erfindungsgemäße Leistungshalbleitermodul weist ein Gehäuse mit wenigstens drei Kontaktierungsbereichen auf. Diese sind dafür vorgesehen, dass eine der beiden Kontaktelektroden oder beide Kontaktelektroden zusammen in jeweils einem der Kontaktierungsbereiche an dem Gehäuse mit einer Strom-/Spannungsquelle über beispielsweise eine Stromschiene kontaktierbar sind.

Werden die beiden Kontaktelektroden beide in dem dritten Kontaktierungsbereich gemeinsam kontaktiert, ergibt sich eine einzige Kontaktelektrode mit einem Querschnitt, der einer Summe der Querschnitte der ersten und der zweiten Kontaktelektrode entspricht. An dieser nun massiveren Kontaktelektrode können hohe elektrische Ströme geleitet werden.

Werden die beiden Kontaktelektroden in dem ersten bzw. zweiten Kontaktierungsbereich mit einer Strom-/Spannungsquelle über beispielsweise eine Stromschiene kontaktiert, ergeben sich zwei einzelne Kontaktelektroden mit einem geringeren Querschnitt als zuvor beschrieben. An diesen weniger massiven Kontaktelektroden können niedrigere Ströme beispielsweise mit Gleichspannungen DC+ und DC- geleitet werden.

Ohne die Konfiguration des Gehäuses des Leistungshalbleitermoduls verändern zu müssen, können mit der Erfindung verschiedene Leistungshalbleiterschaltungen realisiert werden, die unterschiedliche Anforderungen an die Anzahl an Kontaktelektroden und an deren wirksamen Querschnitt haben.

Durch die Erfindung ist eine Reduktion der Gehäusekosten möglich, weil die Kontaktelektroden bei der Herstellung des Gehäuses nicht mit in das eigentliche Gehäuse integriert werden müssen. Die erzielbaren Stückzahlen für das eigentliche Gehäuse können dadurch größer sein, da dieses flexibel für verschiedene Anwendungen einsetzbar ist.

Das Leistungshalbleitermodul ist keineswegs auf zwei Kontaktelektroden und drei Kontaktierungsbereiche beschränkt. Es handelt sich vielmehr um eine Minimalkonfiguration. Es sind auch Leistungshalbleitermodule möglich, die ein ganzzahliges Vielfaches von ersten und zweiten Kontaktelektroden und ein ganzzahliges Vielfaches von drei Kontaktierungsbereichen aufweist. Es können demnach beispielsweise vier Kontaktelektroden und sechs Kontaktierungsbereiche, oder sechs Kontaktelektroden und neun Kontaktierungsbereiche sein. Gleichfalls können weitere Kontaktelektroden und/oder Kontaktierungsbereiche (zusätzlich zu den bislang erwähnten) vorhanden sein.

Im Rahmen einer bevorzugten Weiterbildung der Erfindung sind die erste und zweite Kontaktelektrode (sowie ggf. weitere vorhandene Kontaktelektroden) um jeweils zwei Kanten des Gehäuses biegbar. Die Kanten sind vorteilhafterweise im Bereich der Ausnehmungen ausgebildet, durch welche die Kontaktelektroden jeweils durch das Gehäuse nach außen geführt sind. Mit anderen Worten können die Kontaktelektroden, die nach dem Durchführen durch die Ausnehmungen in dem Gehäuse beispielsweise lotrecht zu einer Außenseite des Gehäuses ausgebildet sind, in eine "waagrechte" Position an die Außenseite des Gehäuses gebogen werden. In den Kontaktierungsbereichen können die dorthin gebogenen Kontaktelektroden dann mit einer Strom-/Spannungsquelle über beispielsweise eine Stromschiene kontaktiert werden.

Vorteilhafterweise weisen die Kanten eine Abrundung auf, um das Biegen der Kontaktelektroden um die Kanten herum zu erleichtern. Zudem kann dadurch einer Beschädigung der jeweiligen Kontaktelektrode durch das Biegen um die jeweilige Kante vorgebeugt werden.

In dem Bereich der Ausnehmungen, in dem die Kontaktelektroden durch das Gehäuse nach außen geführt sind, können diese von einem elektrisch isolierenden Material umgeben sein. Dieses Material kann beispielsweise in die Ausnehmungen hineingespritzt sein.

Im Zuge einer besonders bevorzugten Weiterbildung der Erfindung weist das Gehäuse in den Kontaktierungsbereichen jeweils eine Ausnehmung zur Aufnahme einer Schraube auf, um die Kontaktelektroden jeweils in dem Kontaktierungsbereich, vorzugsweise an einer Außenseite des Gehäuses, mit einer Strom-/Spannungsquelle über beispielsweise eine Stromschiene zu kontaktieren. Dabei weisen die Kontaktelektroden vorzugsweise auch eine entsprechende Ausnehmung zur Aufnahme der Schraube auf. Es gibt vergleichbare Befestigungsmöglichkeiten, aber die Schraubverbindung stellt eine gängige und gut geeignete Methode dar, um Materialien wie die Kontaktelektroden zu verbinden bzw. zu kontaktieren. Zur Sicherung der Schraubverbindung kann das entsprechende Gewindeteil (an einer Innenseite des Gehäuses angeordnet) verwendet werden. Das Gewindeteil kann beispielsweise eine Mutter sein. Um eine Toleranz auszugleichen, können die Ausnehmungen in den Kontaktelektroden jeweils als ein länglich ausgedehntes Loch ausgebildet sein (ein sogenanntes Langloch) .

Bevorzugt weist das Gehäuse in dem dritten Kontaktierungsbereich, in dem die erste und die zweite Kontaktelektrode kontaktierbar sind, eine geringere Dicke auf als in dem ersten und dem zweiten Kontaktierungsbereich. Vorzugsweise ist das Gehäuse derart ausgebildet, dass eine Dicke des Gehäuses in dem dritten Kontaktierungsbereich, in dem beide Kontaktelektroden kontaktierbar sind, so gestaltet ist, dass sich bei einer Anordnung beider Kontaktelektroden in dem dritten Kontaktierungsbereich eine neue (effektive) Dicke des Gehäuses (inkl. Kontaktelektroden) ergibt, der einer Dicke des Gehäuses in dem ersten bzw. zweiten Kontaktierungsbereich entspricht (für den Fall, dass dort die erste bzw. Kontaktelektrode kontaktiert wird).

Die Querschnitte der ersten und zweiten Kontaktelektrode können sich voneinander unterscheiden. Entsprechend kann auch das Gehäuse in dem ersten Kontaktierungsbereich eine Dicke aufweisen, die von einer Dicke in dem zweiten Kontaktierungsbereich verschieden ist. Bevorzugt ist der Unterschied in der Dicke des Gehäuses (ohne Kontaktelektroden) gleich dem Unterschied des Querschnitts der beiden Kontaktelektroden, so dass die beiden Dicken des Gehäuses in dem ersten und dem zweiten Kontaktierungsbereich sich nicht signifikant voneinander unterscheiden, wenn die beiden Kontaktelektroden dort kontaktiert sind.

Besonders bevorzugt ist das das Gehäuse im Wesentlichen quaderförmig mit vier Längsseiten mit einer größeren Fläche und zwei Stirnseiten mit einer kleineren Fläche ausgebildet, wobei sich die Kontaktierungsbereiche in einem mittigen Bereich einer der vier Längsseiten befinden. Mit anderen Worten sind die Kontaktierungsbereiche mittig in dem Gehäuse angeordnet. Hierdurch ergeben sich die folgenden Vorteile:
- Ein symmetrisches Layout innerhalb des Leistungshalbleitermoduls ist möglich → dieses eignet sich besonders für Parallelschaltungen von Halbleiterchips;
- Innerhalb des Leistungshalbleitermoduls bilden sich keine langen Leiterstrukturen aus, so dass sich mehrere parallel geschaltete Leistungshalbleitermodule weniger gegenseitig beeinflussen.

Die zuvor gestellte Aufgabe wird zudem gelöst durch ein Gehäuse für ein Leistungshalbleitermodul, wobei letzteres wie zuvor erläutert ausgebildet ist.

Die Aufgabe wird außerdem gelöst durch ein Verfahren zum Herstellen eines Leistungshalbleitermoduls mit den folgenden Verfahrensschritten:
a) Herstellen einer Leistungshalbleiterschaltung;
b) Verbinden einer ersten Kontaktelektrode und einer zweiten Kontaktelektrode mit der Leistungshalbleiterschaltung, vorzugsweise mittels Löten oder Ultraschallschweißen;
c) Wenigstens teilweises Umgeben der Leistungshalbleiterschaltung mit einem Gehäuse, wobei die erste Kontaktelektrode und die zweite Kontaktelektrode jeweils durch eine hierfür ausgebildete Ausnehmung in dem Gehäuse durch das Gehäuse nach außen geführt werden, wobei das Gehäuse eine erste, eine zweite und einen dritten Kontaktierungsbereich aufweist, und wobei in dem ersten Kontaktierungsbereich die erste Kontaktelektrode und in dem zweiten Kontaktierungsbereich die zweite Kontaktelektroden kontaktierbar ist,
und wobei in dem dritten Kontaktierungsbereich die erste Kontaktelektrode und die zweite Kontaktelektrode zusammen kontaktierbar sind.

In einem zusätzlichen Schritt kann die erste Kontaktelektrode gebogen und in dem ersten Kontaktierungsbereich oder in dem dritten Kontaktierungsbereich mit einer externen Spannungs-/Stromquelle kontaktiert werden, und es kann die zweite Kontaktelektrode gebogen und in dem zweiten Kontaktierungsbereich oder in dem dritten Kontaktierungsbereich kontaktiert werden, wobei die Kontaktierung jeweils vorzugsweise mit Hilfe einer Schraube erfolgt.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung von Ausführungsbeispielen, die im Zusammenhang mit den Zeichnungen näher erläutert werden. Es zeigen:
- FIG 1: ein erfindungsgemäßes Leistungshalbleitermodul in einem ersten Konfigurationsmodus in einer perspektivischen Ansicht;
- FIG 2: das Leistungshalbleitermodul gemäß Fig. 1 in einem zweiten Konfigurationsmodus in einer perspektivischen Ansicht;
- FIG 3: das Leistungshalbleitermodul gemäß Fig. 1 in einem dritten Konfigurationsmodus in einer Draufsicht; und
- FIG 4: ein erfindungsgemäßes Leistungshalbleitermodul in einem Schnittbild.

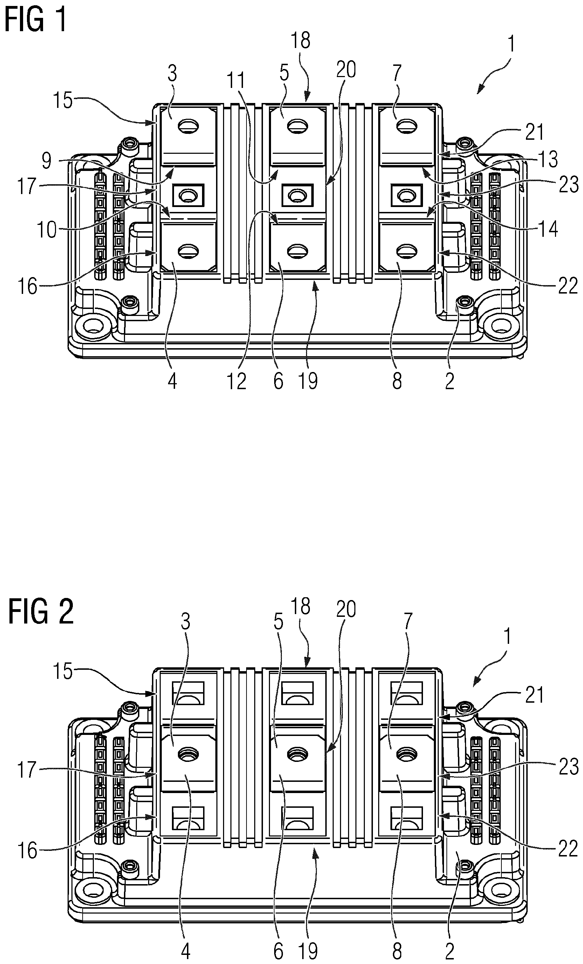

FIG 1 zeigt ein erfindungsgemäßes Leistungshalbleitermodul 1 in einer perspektivischen Ansicht. Das Leistungshalbleitermodul 1 weist ein Gehäuse 2 auf, welches eine in FIG 1 nicht zu erkennende Leistungshalbleiterschaltung in dessen Innerem umgibt. Die Leistungshalbleiterschaltung im Inneren des Gehäuses 2 weist eine erste Kontaktelektrode 3, eine zweite Kontaktelektrode 4, eine dritte Kontaktelektrode 5, eine vierte Kontaktelektrode 6, eine fünfte Kontaktelektrode 7 und eine sechste Kontaktelektrode 8 auf, die elektrische leitend mit der Leistungshalbleiterschaltung verbunden sind.

Die Kontaktelektroden 3, 4, 5, 6, 7, 8 sind durch entsprechend ausgebildete Ausnehmungen 9, 10, 11, 12, 13, 14 durch das Gehäuse 2 nach außen geführt. Nach dem Durchführen durch das Gehäuse 2 sind die Kontaktelektroden 3, 4, 5, 6, 7, 8 derart umgebogen worden, dass sie im Wesentlichen plan an einer Außenseite des Gehäuses 2 anliegen. In den Kontaktelektroden 3, 4, 5, 6, 7, 8 befindet sich jeweils eine kreisförmige Ausnehmung, durch die eine Schraube führbar ist, um die Kontaktelektroden 3, 4, 5, 6, 7, 8 mit einer externen Spannungs-/Stromquelle zu kontaktieren.

Das Gehäuse 2 weist einen ersten Kontaktierungsbereich 15, einen zweiten Kontaktierungsbereich 16, einen dritten Kontaktierungsbereich 17, einen vierten Kontaktierungsbereich 18, einen fünften Kontaktierungsbereich 19, einen sechsten Kontaktierungsbereich 20, einen siebten Kontaktierungsbereich 21, einen achten Kontaktierungsbereich 22 und einen neunten Kontaktierungsbereich 23 auf.

In den Kontaktierungsbereichen 15, 16, 17, 18, 19, 20, 21, 22, 23 weist das Gehäuse 2 jeweils eine Ausnehmung in Form eines kreisförmigen Lochs auf, in die ein Gewindeteil in Form einer Mutter einlegbar oder eingelegt ist (in FIG 1 nicht dargestellt).

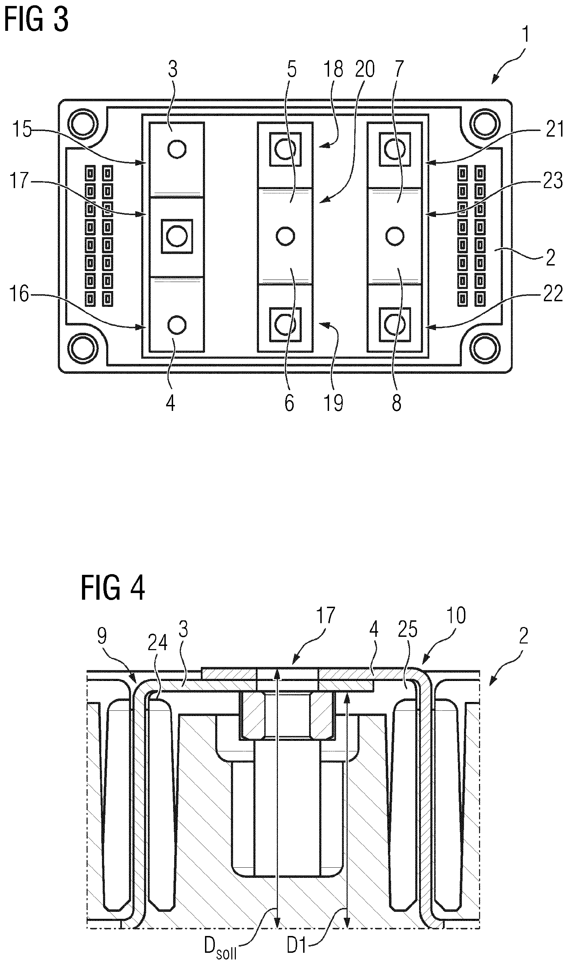

In FIG 1 ist das Leistungshalbleitermodul 1 gemäß einem ersten Konfigurationsmodus ausgebildet. In diesem ist die erste Kontaktelektrode 3 (in FIG 1 nach oben) um eine Kante in dem Gehäuse 2 in den ersten Kontaktierungsbereich 15 gebogen (vgl. hierzu FIG 4) und kann durch eine Schraube (nicht dargestellt) mit einer externen Spannungs-/Stromquelle (nicht dargestellt) in dem ersten Kontaktierungsbereich 15 kontaktiert werden. Die zweite Kontaktelektrode 4 ist in FIG 1 nach unten gebogen und kann durch eine Schraube (nicht dargestellt) mit einer externen Spannungs-/Stromquelle (nicht dargestellt) in dem zweiten Kontaktierungsbereich 16 kontaktiert werden. In dem dritten Kontaktierungsbereich 17 ist keine Kontaktelektrode vorhanden.

Die dritte Kontaktelektrode 5 ist in FIG 1 nach oben gebogen und kann durch eine Schraube (nicht dargestellt) mit einer externen Spannungs-/Stromquelle (nicht dargestellt) in dem vierten Kontaktierungsbereich 18 kontaktiert werden. Die vierte Kontaktelektrode 6 ist in FIG 1 nach unten gebogen und kann durch eine Schraube (nicht dargestellt) mit einer externen Spannungs-/Stromquelle (nicht dargestellt) in dem fünften Kontaktierungsbereich 19 kontaktiert werden. In dem sechsten Kontaktierungsbereich 20 ist keine Kontaktelektrode vorhanden.

Die fünfte Kontaktelektrode 7 ist in FIG 1 nach oben gebogen und kann durch eine Schraube (nicht dargestellt) mit einer externen Spannungs-/Stromquelle (nicht dargestellt) in dem siebten Kontaktierungsbereich 21 kontaktiert werden. Die sechste Kontaktelektrode 8 ist in FIG 1 nach unten gebogen und kann durch eine Schraube (nicht dargestellt) mit einer externen Spannungs-/Stromquelle (nicht dargestellt) in dem achten Kontaktierungsbereich 22 kontaktiert werden. In dem neunten Kontaktierungsbereich 23 ist keine Kontaktelektrode vorhanden.

FIG 2 zeigt das erfindungsgemäße Leistungshalbleitermodul 1 in einem zweiten Konfigurationsmodus. In diesem ist die erste Kontaktelektrode 3 (in FIG 2 nach unten) um eine Kante in dem Gehäuse 2 in den dritten Kontaktierungsbereich 17 gebogen (vgl. hierzu FIG 4) und kann durch eine Schraube (nicht dargestellt) mit einer externen Spannungs-/Stromquelle (nicht dargestellt) in dem dritten Kontaktierungsbereich 17 kontaktiert werden. Die zweite Kontaktelektrode 4 ist in FIG 2 nach oben gebogen und kann durch eine Schraube (nicht dargestellt) gemeinsam mit der ersten Kontaktelektrode 3 mit einer externen Spannungs-/Stromquelle (nicht dargestellt) in dem dritten Kontaktierungsbereich 17 kontaktiert werden. In dem ersten Kontaktierungsbereich 15 und in dem zweiten Kontaktierungsbereich 16 sind keine Kontaktelektroden vorhanden. Durch die Überlagerung der ersten und zweiten Kontaktelektroden 3, 4 in dem dritten Kontaktierungsbereich 17 ergibt sich eine neue Kontaktelektrode, deren Querschnitt einer Summe des jeweiligen Querschnitts der ersten und zweiten Kontaktelektroden 3, 4 entspricht. Diese massivere Kontaktelektrode kann die in dem zweiten Konfigurationsmodus benötigten, höheren Leistungen bzw. Ströme zu der Leistungshalbleiterschaltung transportieren.

In FIG 2 ist die dritte Kontaktelektrode 5 (in FIG 2 nach unten) um eine Kante in dem Gehäuse 2 in den sechsten Kontaktierungsbereich 20 gebogen (vgl. hierzu FIG 4) und kann durch eine Schraube (nicht dargestellt) mit einer externen Spannungs-/Stromquelle in dem sechsten Kontaktierungsbereich 20 kontaktiert werden. Die vierte Kontaktelektrode 6 ist in FIG 2 nach oben gebogen und kann durch eine Schraube (nicht dargestellt) gemeinsam mit der dritten Kontaktelektrode 5 mit einer externen Spannungs-/Stromquelle in dem sechsten Kontaktierungsbereich 20 kontaktiert werden. In dem vierten Kontaktierungsbereich 18 und in dem fünften Kontaktierungsbereich 21 sind keine Kontaktelektroden kontaktiert.

In FIG 2 ist zudem die fünfte Kontaktelektrode 7 (in FIG 2 nach unten) um eine Kante in dem Gehäuse 2 in den neunten Kontaktierungsbereich 23 gebogen (vgl. hierzu FIG 4) und kann durch eine Schraube (nicht dargestellt) mit einer externen Spannungs-/Stromquelle in dem neunten Kontaktierungsbereich 23 kontaktiert werden. Die fünfte Kontaktelektrode 7 ist in FIG 2 nach oben gebogen und kann durch eine Schraube (nicht dargestellt) gemeinsam mit der sechsten Kontaktelektrode 8 mit einer externen Spannungs-/Stromquelle in dem neunten Kontaktierungsbereich 23 kontaktiert werden. In dem siebten Kontaktierungsbereich 21 und in dem achten Kontaktierungsbereich 22 sind keine Kontaktelektroden kontaktiert.

In den Kontaktierungsbereichen 15, 16, 17, 18, 19, 20, 21, 22, 23 weist das Gehäuse 2 in FIG 2 jeweils eine Ausnehmung in Form eines länglich ausgedehnten Lochs (rechteckförmig) auf, die als ein "Langloch" fungiert, um eine Schraube durch die jeweilige Kontaktelektrode 3, 4, 5, 6, 7, 8 mit einer gewissen Toleranz durch das Gehäuse 2 führen zu können.

Wesentlich ist, dass in dem zweiten Konfigurationsmodus dasselbe Gehäuse 2 verwendet werden kann wie im ersten Konfigurationsmodus (vgl. FIG 1).

In FIG 3 ist ein erfindungsgemäßes Leistungshalbleitermodul 1 in einem dritten Konfigurationsmodus in einer Draufsicht dargestellt. In FIG 3 ist die erste Kontaktelektrode 3 (in FIG 3 nach oben) um eine Kante in dem Gehäuse 2 in den ersten Kontaktierungsbereich 15 gebogen (vgl. hierzu FIG 4) und kann durch eine Schraube (nicht dargestellt) mit einer externen Spannungs-/Stromquelle in dem ersten Kontaktierungsbereich 15 kontaktiert werden. Die zweite Kontaktelektrode 4 ist in FIG 2 nach unten gebogen und kann durch eine Schraube (nicht dargestellt) mit einer externen Spannungs-/Stromquelle in dem zweiten Kontaktierungsbereich 16 kontaktiert werden. In dem dritten Kontaktierungsbereich 17 sind keine Kontaktelektroden kontaktiert.

Die dritte Kontaktelektrode 5 ist (in FIG 3 nach unten) um eine Kante in dem Gehäuse 2 in den sechsten Kontaktierungsbereich 20 gebogen (vgl. hierzu FIG 4) und kann durch eine Schraube (nicht dargestellt) mit einer externen Spannungs-/Stromquelle in dem sechsten Kontaktierungsbereich 20 kontaktiert werden. Die vierte Kontaktelektrode 6 ist in FIG 2 nach oben gebogen und kann durch eine Schraube (nicht dargestellt) mit einer externen Spannungs-/Stromquelle in dem sechsten Kontaktierungsbereich 20 gemeinsam mit der dritten Kontaktelektrode 5 kontaktiert werden. In dem vierten Kontaktierungsbereich 18 und in dem fünften Kontaktierungsbereich 19 sind keine Kontaktelektroden kontaktiert.

Die fünfte Kontaktelektrode 7 ist (in FIG 3 nach unten) um eine Kante in dem Gehäuse 2 in den neunten Kontaktierungsbereich 23 gebogen (vgl. hierzu FIG 4) und kann durch eine Schraube (nicht dargestellt) mit einer externen Spannungs-/Stromquelle in dem neunten Kontaktierungsbereich 23 kontaktiert werden. Die sechste Kontaktelektrode 8 ist in FIG 2 nach oben gebogen und kann durch eine Schraube (nicht dargestellt) mit einer externen Spannungs-/Stromquelle in dem neunten Kontaktierungsbereich 23 gemeinsam mit der fünften Kontaktelektrode 7 kontaktiert werden. In dem siebten Kontaktierungsbereich 21 und in dem achten Kontaktierungsbereich 22 sind keine Kontaktelektroden kontaktiert.

In den Kontaktierungsbereichen 15, 16, 17, 18, 19, 20, 21, 22, 23 weist das Gehäuse 2 in FIG 3 jeweils eine vorgezeichnete, aber noch nicht durchstoßene Ausnehmung in Form eines kreisförmigen Lochs auf, um eine Schraube durch die jeweilige Kontaktelektrode 3, 4, 5, 6, 7, 8 mit einer gewissen Toleranz durch das Gehäuse 2 führen zu können (wobei dabei das Gehäuse 2 durchstoßen wird).

Wesentlich ist, dass in dem dritten Konfigurationsmodus dasselbe Gehäuse 2 verwendet werden kann wie im ersten und im zweiten Konfigurationsmodus (vgl. FIG 1 und FIG 2).

In dem dritten Konfigurationsmodus kann das Leistungshalbleitermodul 1 beispielsweise für eine 3L-Leistungshalbleiterschaltung verwendet werden. In dem ersten Kontaktierungsbereich 15 kann die erste Kontaktelektrode für einen Gleichspannungsanschluss "DC+", in dem zweiten Kontaktierungsbereich 16 kann die zweite Kontaktelektrode 16 für einen Gleichspannungsanschluss "DC-" verwendet werden. In dem sechsten Kontaktierungsbereich 20 kann eine Überlagerung der dritten Kontaktelektrode 3 mit der vierten Kontaktelektrode 4 als Gleichspannungsmittelpunktsanschluss "DCM" verwendet werden. Eine Überlagerung der fünften Kontaktelektrode 5 mit der sechsten Kontaktelektrode 6 in dem neunten Kontaktierungsbereich 23 kann als Wechselspannungsanschluss "AC" verwendet werden.

In FIG 4 ist ein Querschnitt eines Gehäuses 2 eines erfindungsgemäßen Leistungshalbleitermoduls 1 dargestellt. Es sind eine erste Kontaktelektrode 3 und eine zweite Kontaktelektrode 4 zu erkennen. Die beiden Kontaktelektroden 3, 4 sind durch das Gehäuse 2 nach außen hindurchgeführt und jeweils um eine Kante 24, 25 gebogen. Die Kanten 24, 25 weisen jeweils eine Abrundung auf, um das Biegen der Kontaktelektroden 3, 4 um die Kanten 24, 25 zu erleichtern. In einem Bereich der Ausnehmungen 9, 10, durch welche die Kontaktelektroden 3, 4 durch das Gehäuse 2 nach außen geführt sind, sind diese von einem elektrisch isolierenden Material umgeben. In den Ausnehmungen 9, 10 sind die beiden Kontaktelektroden 3, 4 damit geführt, wodurch die beim Biegen entstehenden Kräfte gut aufgenommen werden können, ohne eine Verbindung der Kontaktelektroden 3, 4 zu der Leistungshalbleiterschaltung zu beschädigen.

In dem dritten Kontaktierungsbereich 17, in dem die erste und zweite Kontaktelektroden 3, 4 übereinander an dem Gehäuse 2 kontaktierbar sind, ist eine Dicke D1 des Gehäuses 2 so ausgebildet, dass er einer Solldicke DSoll des Gehäuses 2 abzüglich der Summe der Querschnitte der beiden Kontaktelektroden 3, 4 entspricht. Mit anderen Worten ist das Gehäuse 2 in dem dritten Kontaktierungsbereich 17 so vertieft, dass es bei einer Anordnung beider Kontaktelektroden 3, 4 in diesem Bereich zu einer effektiven Dicke des Gehäuses 2 kommt, welches dieses einheitlich nach außen aufweisen soll. Entsprechend sind der erste Kontaktierungsbereich 15 und der zweite Kontaktierungsbereich 16 jeweils um einen Querschnitt der ersten Kontaktelektrode 3 bzw. der zweiten Kontaktelektrode 4 gegenüber der Solldicke DSoll vertieft (in FIG 4 nicht dargestellt).

Obwohl die Erfindung im Detail durch das bevorzugte Ausführungsbeispiel näher illustriert und beschrieben wurde, so ist die Erfindung nicht auf die offenbarten Beispiele eingeschränkt und andere Variationen können vom Fachmann hieraus abgeleitet werden, ohne den Schutzumfang der Erfindung zu verlassen.

## Patentansprüche

1. Leistungshalbleitermodul (1), das eine Leistungshalbleiterschaltung und ein Gehäuse (2) aufweist,
wobei das Gehäuse (2) die Leistungshalbleiterschaltung wenigstens teilweise umgibt,
und wobei die Leistungshalbleiterschaltung eine erste Kontaktelektrode (3) und eine zweite Kontaktelektrode (4) aufweist, die jeweils mit der Leistungshalbleiterschaltung elektrisch leitend verbunden sind, und die jeweils durch eine hierfür ausgebildete Ausnehmung (9, 10) in dem Gehäuse (2) durch das Gehäuse (2) nach außen geführt sind,
**dadurch gekennzeichnet, dass**
das Gehäuse (2) einen ersten Kontaktierungsbereich (15), einen zweiten Kontaktierungsbereich (16) und einen dritten Kontaktierungsbereich (17) aufweist, wobei in dem ersten Kontaktierungsbereich (15) die erste Kontaktelektrode (3) kontaktierbar ist, und in dem zweiten Kontaktierungsbereich (16) die zweite Kontaktelektrode (4) kontaktierbar ist, und dass in dem dritten Kontaktierungsbereich (17) die erste Kontaktelektrode (3) und die zweite Kontaktelektrode (4) zusammen kontaktierbar sind.

2. Leistungshalbleitermodul (1) nach Anspruch 1, das ein ganzzahliges Vielfaches von ersten und zweiten Kontaktelektroden (3, 4, 5, 6, 7, 8) und ein ganzzahliges Vielfaches von drei Kontaktierungsbereichen (15, 16, 17, 18, 19, 20, 21, 22, 23) aufweist, wobei die Kontaktelektroden (3, 4, 5, 6, 7, 8) und die Kontaktierungsbereiche (15, 16, 17, 18, 19, 20, 21, 22, 23) an dem Gehäuse (2) jeweils gemäß Anspruch 1 ausgebildet sind.

3. Leistungshalbleitermodul (1) nach Anspruch 1 oder 2, bei dem die erste Kontaktelektrode (3) und die zweite Kontaktelektrode (4) jeweils um wenigstens zwei Kanten (24, 25) des Gehäuses (2) biegbar sind.

4. Leistungshalbleitermodul (1) nach Anspruch 3, bei dem die Kanten (24, 25) eine Abrundung aufweisen, um das Biegen der Kontaktelektroden (3, 4, 5, 6, 7, 8) zu erleichtern.

5. Leistungshalbleitermodul (1) nach einem der vorangegangenen Ansprüche, bei dem die Kontaktelektroden (3, 4, 5, 6, 7, 8) in einem Bereich der Ausnehmungen (9, 10, 11, 12, 13, 14), durch welche die Kontaktelektroden (3, 4, 5, 6, 7, 8) durch das Gehäuse (2) nach außen geführt sind, von einem elektrisch isolierenden Material umgeben sind.

6. Leistungshalbleitermodul (1) nach einem der vorangegangenen Ansprüche, bei dem das Gehäuse (2) in den Kontaktierungsbereichen (15, 16, 17, 18, 19, 20, 21, 22, 23) jeweils eine Ausnehmung aufweist, in welcher vorzugsweise ein Gewindeteil eingesetzt ist, wobei die Ausnehmung, und vorzugsweise das Gewindeteil, zur Aufnahme einer Schraube ausgebildet sind, um die Kontaktelektroden (3, 4, 5, 6, 7, 8) jeweils in dem Kontaktierungsbereich (15, 16, 17, 18, 19, 20, 21, 22, 23) mit einer externen Spannungs-/Stromquelle zu kontaktieren, vorzugsweise an einer Außenseite des Gehäuses (2), wobei die Kontaktelektroden (3, 4, 5, 6, 7, 8) vorzugsweise ebenfalls eine Ausnehmung zur Aufnahme der Schraube aufweisen.

7. Leistungshalbleitermodul (1) nach Anspruch 6, bei dem die Ausnehmungen in den Kontaktelektroden (3, 4, 5, 6, 7, 8) jeweils als ein länglich ausgedehntes Loch ausgebildet sind.

8. Leistungshalbleitermodul (1) nach einem der vorangegangenen Ansprüche, bei dem das Gehäuse (2) in dem dritten Kontaktierungsbereich (17), in dem die erste Kontaktelektrode (3) und die zweite Kontaktelektrode (4) kontaktierbar sind, eine geringere Dicke (D1) aufweist als in dem ersten Kontaktierungsbereich (15) und in dem zweiten Kontaktierungsbereich (16).

9. Leistungshalbleitermodul (1) nach einem der vorangegangenen Ansprüche, bei dem das Gehäuse (2) in dem ersten Kontaktierungsbereich (15) eine Dicke aufweist, die von einer Dicke dem zweiten Kontaktierungsbereich (16) verschieden ist.

10. Leistungshalbleitermodul (1) nach einem der vorangegangenen Ansprüche, bei dem das Gehäuse (2) im Wesentlichen quaderförmig mit vier Längsseiten mit einer größeren Fläche und zwei Stirnseiten mit einer kleineren Fläche ausgebildet ist, wobei sich die Kontaktierungsbereiche (15, 16, 17, 18, 19, 20, 21, 22, 23) in einem mittigen Bereich einer der vier Längsseiten befinden.

11. Gehäuse (2) für ein Leistungshalbleitermodul (1), wobei das Leistungshalbleitermodul (1) gemäß einem der Ansprüche 1 bis 10 ausgebildet ist.

12. Leistungshalbleitermodulsystem mit einer Vielzahl von Leistungshalbleitermodulen (1), die gemäß einem der Ansprüche 1 bis 10 ausgebildet sind.

13. Verfahren zum Herstellen eines Leistungshalbleitermoduls (1), umfassend:
a) Herstellen einer Leistungshalbleiterschaltung;
b) Verbinden einer ersten Kontaktelektrode (3) und einer zweiten Kontaktelektrode (4) mit der Leistungshalbleiterschaltung, vorzugsweise mittels Löten oder Ultraschallschweißen;
c) Wenigstens teilweises Umgeben der Leistungshalbleiterschaltung mit einem Gehäuse (2), wobei die erste Kontaktelektrode (3) und die zweite Kontaktelektrode (4) jeweils durch eine hierfür ausgebildete Ausnehmung (9, 10) in dem Gehäuse (2) durch das Gehäuse (2) nach außen geführt werden, wobei das Gehäuse (2) einen ersten Kontaktierungsbereich (15), einen zweiten Kontaktierungsbereich (16) und einen dritten Kontaktierungsbereich (17) aufweist, und wobei in dem ersten Kontaktierungsbereich (15) die erste Kontaktelektrode (3) und in dem zweiten Kontaktierungsbereich (16) die zweite Kontaktelektrode (4) kontaktierbar ist,
und wobei in dem dritten Kontaktierungsbereich (17) die erste Kontaktelektrode (3) und die zweite Kontaktelektrode (4) zusammen kontaktierbar sind.

14. Verfahren nach Anspruch 13, bei dem die erste Kontaktelektrode (3) gebogen und in dem ersten Kontaktierungsbereich (15) oder in dem dritten Kontaktierungsbereich (17) mit einer externen Spannungs-/Stromquelle kontaktiert wird, und bei dem die zweite Kontaktelektrode (4) gebogen und in dem zweiten Kontaktierungsbereich (16) oder in dem dritten Kontaktierungsbereich (17) mit einer externen Spannungs-/Stromquelle kontaktiert wird, wobei die Kontaktierung jeweils vorzugsweise mit Hilfe einer Schraube erfolgt.
